# FASCICULE DE BREVET EUROPEEN

(11) **EP 0 341 108 B1**
(45) Date de publication et mention de la délivrance du brevet: **10.11.1993**
(21) Numéro de dépôt: 89401060.2
(22) Date de dépôt: 18.04.1989
(51) Int. Cl.: F04D 13/06, F04D 15/00, G01R 31/34

(54) **Groupe motopompe comportant un système de palier arrière à circulation combiné à un détecteur électrique de sens de rotation**
Motorpumpeneinheit mit gespültem Hinterlagersystem und kombiniertem elektrischem Drehsinndetektor
Motor pump assembly comprising a flushed rear-bearing system combined with an electrical rotation direction detector

(30) Priorité: 06.05.1988 FR 8806109
(43) Date de publication de la demande: 08.11.1989
(73) Titulaire: POMPES SALMSON Société Anonyme à directoire dite:, 92500 Rueil Malmaison (FR)
(72) Inventeur: Brunel,Roland Jacques, F-53260 L'Huisserie (FR); Kernours,Michel Roger Jean-Marie, F-35370 Montdevert (FR)
(74) Mandataire: Hirsch, Marc-Roger

(56) Documents cités:
- DE-A- 1 403 837
- DE-A- 1 763 760
- DE-A- 1 956 632
- FR-A- 1 085 115
- US-A- 2 688 946
- US-A- 3 067 690
- US-A- 4 334 189

## Description

La présente invention se rapporte à un groupe motopompe, notamment pour un circuit d'eau de chauffage, comportant un arbre de rotor porté par deux paliers et solidaire d'un rotor de moteur électrique noyé dans un circuit d'eau de rotor qui est délimité par un tube d'entrefer du moteur électrique et est établi en dérivation entre la périphérie du rotor de pompe et un retour axial via un passage de l'arbre du rotor du moteur, le système de palier arrière de l'axe du moteur, situé du côté opposé au rotor de pompe comportant au moins un passage de palier branché en dérivation du circuit de liquide de rotor qui revient au circuit aval de la pompe à travers l'arbre du rotor du moteur électrique, de manière à réaliser la purge automatique du circuit d'eau de rotor et notamment de la zone dudit palier arrière, l'extrémité de l'arbre de rotor du moteur électrique située près dudit palier arrière comportant au moins un passage radial de retour au circuit de liquide de rotor débouchant sur le passage axial de l'arbre de rotor de moteur électrique.

De nombreux groupes motopompes, en particulier ceux entraînés par des moteurs électriques à rotor noyé équipant des circulateurs de chauffage central comportent, du côté opposé au rotor de la pompe, un palier arrière qui remplit, en plus de sa fonction de palier, une fonction supplémentaire de détecteur de la rotation du rotor du moteur électrique et d'accès de dégommage vers le rotor du moteur. A cette fin, l'arbre du rotor du moteur électrique débouche à son extrémité sur une chambre de palier qui n'est reliée au circuit d'eau de rotor que par le mince passage annulaire formant coin de graissage et ménagé entre la surface extérieure cylindrique de l'arbre et la surface cylindrique intérieure de l'alésage de palier. Cette chambre de palier est isolée de l'extérieur de façon étanche au liquide véhiculé par la pompe et est, en général, séparée de l'extérieur soit par une paroi transparente permettant de voir en permanence l'extrémité de l'arbre qui porte une fente de repérage de la rotation et de dégommage, soit par un bouchon étanche et amovible qui, une fois déposé pour examen du rotor de pompe, permet de réaliser le dégommage du rotor de moteur électrique encagé dans un tube d'entrefer l'isolant de l'extérieur et permet de s'assurer, le cas échéant, de la mise en rotation effective du rotor soit directe, soit après dégommage de celui-ci.

Le mince passage annulaire entre la chambre de palier et le liquide véhiculé par la pompe évite que l'ouverture de la chambre de palier ne se traduise par une fuite importante du liquide véhiculé par la pompe pendant l'observation ou le dégommage de l'arbre de rotor du moteur.

Ces dispositions connues présentent l'inconvénient d'être relativement onéreuses et de ne pas fournir d'information sur le sens de rotation du moteur qui constitue l'information qui est le plus souvent réclamée pour les groupes motopompes de puissance moyenne, c'est-à-dire ceux entraînés par des moteurs asynchrones triphasés. En effet, au moment du branchement d'un moteur asynchrone triphasé, il existe une chance sur deux que le branchement réalisé conduise à une rotation du rotor de pompe centrifuge dans le sens où les aubages du rotor sont inclinés vers l'avant, c'est-à-dire dans le sens de déplacement tangentiel, ce qui constitue un sens de rotation à très mauvais rendement de pompage. Il est donc nécessaire de repérer le sens de rotation du moteur asynchrone après son branchement et d'intervertir l'ordre des phases si le moteur se révèle tourner dans le mauvais sens, ce qui n'est pas aisé à détecter dans les groupes motopompes actuels complètement fermés.

Une autre difficulté qui apparaît également souvent pour les groupes motopompes de puissance faible et moyenne est due au fait que la chambre de palier tend à rester dans l'air après la mise en service de la pompe si on ne prévoit pas une ouverture de purge de cette chambre de palier, cette ouverture de purge devant rester ouverte au cours du remplissage de la pompe en liquide et quelque temps après la mise en service de la pompe.

DE-A-1403837 et DE-A-1956632 décrivent des pompes à tube d'entrefer dans lesquelles le palier arrière comporte une chambre de palier alimentée en liquide pompé soit par le passage annulaire entre la surface extérieure de l'arbre de rotor et la surface intérieure du palier, soit par des passages de palier, le liquide de cette chambre étant ensuite évacué par un passage central de l'arbre vers l'aspiration du rotor de pompe. Une telle disposition assure une certaine purge automatique de l'air de la chambre de palier mais ne permet pas de contrôler le sens de rotation et la mise en rotation du rotor de pompe afin de pouvoir remédier rapidement à une défaillance indiquée par les informations fournies au sujet de la rotation.

La présente invention a pour but de pallier les inconvénients qui viennent d'être exposés tout en réduisant les difficultés et le coût de fabrication des groupes motopompes actionnés par un moteur électrique asynchrone, notamment par un moteur asynchrone triphasé.

A cet effet, selon l'invention, un moyen d'étanchéité tournante au moins partielle est interposé entre l'arbre de rotor du moteur électrique et le support de palier arrière, pour isoler au moins partiellement ledit passage de dérivation de la face d'extrémité de l'arbre de rotor qui débouche sur une chambre de palier fermée par un bouchon amovible permettant d'observer cette face d'extrémité de l'arbre pour déterminer si l'arbre tourne, et dans le cas où il ne tourne pas alors que le moteur électrique est sous tension, procéder à son dégommage.

Selon un mode de réalisation particulier, le système de palier coopère avec un détecteur électrique du sens de rotation du rotor du moteur électrique.

Dans le cas où le moteur électrique est un moteur asynchrone triphasé, le détecteur électrique du sens de rotation est constitué par un circuit déphaseur résistance-capacité branché entre les deux premières phases du moteur électrique alors qu'un circuit diviseur de tension à deux résistances supplémentaires est branché d'une part entre la résistance et le condensateur du circuit déphaseur et, d'autre part, à la dernière phase du moteur électrique, et un détecteur de tension minimale tel qu'un tube néon est branché aux bornes de celles des deux résistances supplémentaires qui est branchée entre la résistance et le condensateur du circuit déphaseur, la présence d'une tension minimale sur le détecteur de tension indiquant un premier sens de rotation du moteur électrique et l'absence de tension indiquant le deuxième sens de rotation du moteur électrique.

Selon un autre mode de réalisation particulier avec un moteur électrique asynchrone triphasé, le détecteur électrique comporte deux premiers circuits déphaseurs résistance-capacité branchés entre deux premières phases du moteur électrique en parallèle et selon des positions résistance-capacité opposées, deux circuits diviseurs de tension à deux résistances supplémentaires et correspondant chacun à l'un des deux circuits déphaseurs étant branchés, d'une part entre la résistance et le condensateur du circuit déphaseur correspondant et, d'autre part, la troisième phase du moteur électrique et un détecteur de tension minimale tel qu'un tube néon étant branchés aux bornes de celle des deux résistances supplémentaires qui est branchée entre la résistance et le condensateur du circuit déphaseur, de manière que la présence d'une tension minimale sur le premier détecteur de tension indique un premier sens de rotation du moteur et que la présence d'une tension minimale sur le deuxième détecteur de tension indique le deuxième sens de rotation du moteur électrique.

Le détecteur de tension est de préférence monté sur un boîtier de surveillance ou de télésurveillance du moteur, en indicateur unique pour servir simultanément de détecteur du sens de rotation correct du moteur et de détecteur de la présence de la tension d'alimentation du moteur électrique.

D'autres buts, avantages et caractéristiques apparaîtront à la lecture de la description de plusieurs modes de réalisation de l'invention, faite à titre non limitatif et en regard du dessin annexé où:
- - la figure 1: est une vue en coupe longitudinale d'un groupe motopompe de type courant pour circulateur de chauffage central et susceptible d'être équipé du système de palier arrière combiné à un détecteur électrique de sens de rotation, selon l'invention;
- - la figure 2: est une vue en coupe à plus grande échelle et avec arrachements d'un système de palier arrière à recirculation de type connu et qui a servi de base au mode de réalisation selon l'invention;
- - la figure 3: est une vue similaire à celle de la figure 2 d'un mode de réalisation du système de palier arrière selon l'invention;
- - la figure 4: est une représentation schématique d'un circuit de détection du sens de rotation du moteur, appliqué au groupe motopompe selon l'invention;
- - la figure 5: est une représentation schématique d'un autre mode de réalisation du circuit de détection de sens de rotation du moteur appliqué au groupe motopompe selon l'invention.

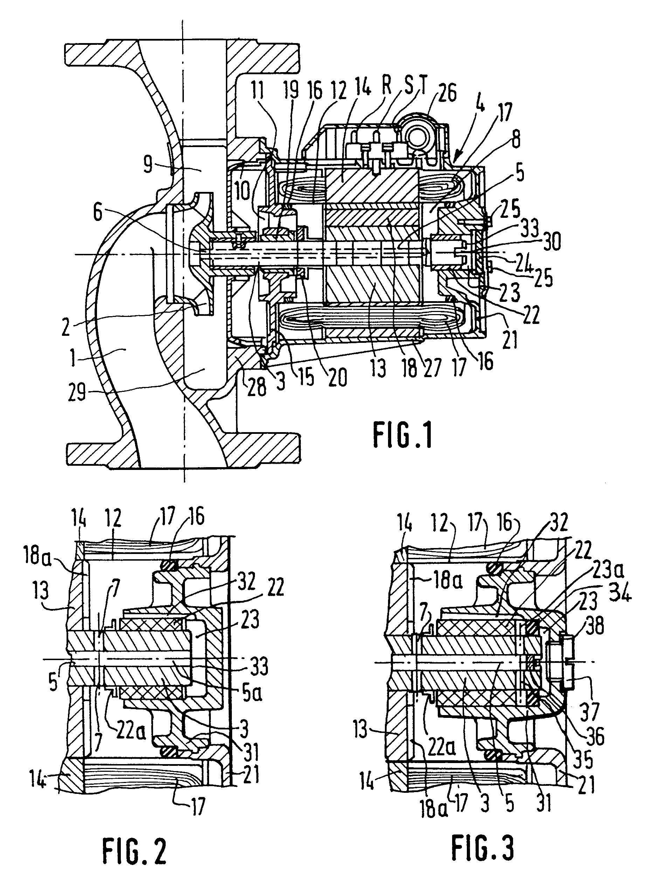

En se reportant à la figure 1, on voit les principaux éléments constituant le groupe motopompe destiné à être équipé d'un système de palier arrière selon l'invention.

Un circuit d'aspiration 1 de la pompe débouche sur l'entrée d'un rotor de pompe 2 relié à l'arbre 3 d'un moteur électrique d'actionnement 4. L'arbre 3 présente un passage central foré 5 qui débouche, d'une part, sur un orifice central 6 du rotor de pompe 2 et, d'autre part, sur des passages radiaux 7 d'une chambre de rotor 8 reliée à la chambre de refoulement 9 de la pompe par des passages axiaux 10 et 11. La chambre de rotor 8 est délimitée de façon étanche par un tube d'entrefer 12 réalisé, en général, par un mince tube d'acier inoxydable logé dans l'entrefer entre le rotor 13 et le stator 14 du moteur électrique et étanché à chaque extrémité sur un flasque (par exemple le flasque avant 15) du moteur par l'intermédiaire de joints toriques d'étanchéité 16.

Le stator 14 du moteur électrique présente une série circonférentielle d'encoches dans lesquelles sont logées les bobines 17 du circuit électrique stator destinées à être reliées à un circuit électrique d'alimentation en courant alternatif monophasé (solution en général à phase auxiliaire avec un condensateur pour les pompes) ou triphasé du réseau domestique ou industriel (phases R, S, T). Le rotor 13 présente en général un circuit électrique en cage d'écureuil dont les barreaux 18 sont reliés entre eux par deux anneaux d'extrémité de court-circuit 18a. Les flasques du moteur électrique portent chacun un palier pour l'arbre 3 du moteur et du rotor de pompe. Le flasque 15 porte ici un palier lisse en graphite 19 combiné à une butée 20 en céramique et orientée pour tenir compte du fait que la chambre de rotor 8 reliée à l'aval du rotor de pompe 2 est normalement en surpression par rapport du circuit d'aspiration 1. Le flasque arrière 21 porte un palier arrière lisse en graphite 22 à l'intérieur duquel tourne avec un faible jeu l'extrémité de l'arbre 3 du moteur pour délimiter une chambre de palier 23 qui n'est reliée à la chambre de rotor 8 que par le faible jeu existant entre l'arbre 3 et le palier 22. La chambre de palier 23 est obturée vers l'extérieur par une plaque transparente 24 serrée de façon étanche sur le flasque 21 par une couronne de vis 25. Le moteur électrique 4 est en général surmonté d'une boîte à bornes 26 où sont branchées les trois phases R, S, T reliées au bobinage stator du moteur constitué par des séries de bobines 17 qui sont enfermées et protégées de tout contact ou pollution extérieure par une enveloppe de moteur 27 faisant ici corps avec le flasque arrière 21. Cette enveloppe 27 est fixée en fait sur le corps de pompe 28 contenant la chambre d'admission 1, la chambre de refoulement 9 et le rotor de pompe 2 logé dans une chambre de rotor 29.

Le groupe motopompe selon l'état de la technique et représenté à la figure 1 nécessite diverses manoeuvres et contrôles pour sa mise en service. Après le branchement du groupe motopompe sur son circuit de liquide (ici un circuit d'eau chaude de chauffage), il est nécesaire de procéder au remplissage de la chambre de rotor 8 et, si possible, de la chambre de palier 23. Pour cela, l'opérateur desserre les vis 25 pour créer une fuite d'air de purge débouchant sur la chambre de palier 23 et, via le passage annulaire entre l'arbre 3 et le palier 22, sur la chambre de rotor 8. En général, une fuite de liquide apparaît avant la purge complète de la chambre de rotor 8. L'opérateur met ensuite en marche le moteur électrique 4 et repère son sens de rotation en observant une fente 30 ménagée à l'extrémité de l'arbre 3. Si le sens de rotation de l'arbre 3, et donc du rotor de pompe 2 est incorrect, l'opérateur doit procéder à l'interversion du branchement de deux des phases R, S, T du réseau triphasé.

Lorsque le moteur tourne dans le sens correct, la surpression régnant dans la chambre de refoulement 9 par rapport à la pression régnant à l'aspiration 1 provoque une circulation d'eau via les passages 10, 11 et l'intervalle d'entrefer entre le rotor 13 et le tube de rotor 12 jusqu'aux trous radiaux 7 permettant le retour à l'aspiration de la pompe par le passage foré 5 et l'orifice central 6 du rotor de pompe 2. La chambre de rotor 8 s'étant remplie et presque complètement purgée d'air, l'opérateur peut alors à nouveau desserrer les vis 25 pour laisser s'évacuer l'air de la chambre de palier 23 qui est progressivement remplacé par du liquide refoulé par la pompe (ici de l'eau chaude). La purge du circuit de pompe étant réalisée, l'opérateur serre à nouveau les vis 25 pour étancher le circuit de pompe. Au cours du fonctionnement de la pompe, on pourra observer l'arrêt ou la rotation de l'arbre 3 à travers la plaque transparente 24 pour autant qu'elle ne soit pas rendue opaque après quelques années de service. En cas de blocage ou de gommage du rotor 13 dans son tube d'entrefer 12, on peut faire tourner le rotor 13, par exemple à l'aide d'un tournevis engagé dans la fente 30.

Le besoin s'est exprimé de disposer d'une circulation de liquide dans la chambre de palier 23 pour faire face à des échauffements exagérés du palier 22 causés par un serrage de ce palier (par exemple à cause d'un dépôt intercalaire) ne mettant cependant pas en cause la bonne marche de la pompe, mais une telle circulation provoque des fuites exagérées avec risque corporel en cas de démontage de la plaque transparente 24 pour accéder à la fente 30 de l'arbre 3.

Le système de palier arrière selon l'invention représenté sur la figure 3 et issu d'une modification de celui représenté à la figure 2 remédie à ces difficultés. Les éléments identiques portent les mêmes numéros de référence qu'à la figure 1. On voit sur la figure 2 qui représente un palier arrière à recirculation de type connu, la chambre de rotor 8 délimitée entre le tube d'entrefer 12, le rotor 13 et un support de palier 31 rapporté au centre du flasque 21 et coopérant avec le joint torique 16 du tube d'entrefer. La chambre de palier 23 délimitée entre le support de palier 31, le palier 22 et l'extrémité de l'arbre 3, est reliée par au moins un passage axial 32 à la chambre de rotor 8 et le passage foré 5 de l'arbre 3 débouche par un prolongement 5a sur cette chambre de palier 23. Les passages radiaux 7 présentant une section limitée, on voit que lorsque le rotor 13 du moteur électrique 4 tourne, le rotor de pompe 2 refoule du liquide dans la chambre de palier 8 et qu'il s'établit une circulation de liquide en dérivation des passages radiaux 7, via un passage de palier constitué du passage axial 32, de la chambre de palier 23 et du prolongement 5a du trou foré 5. La chambre de palier 23 est ainsi soumise à une circulation de retour vers l'aspiration 1 de la pompe et il n'est plus nécessaire de prévoir au démarrage de la pompe une purge spéciale de l'air qu'elle contient car, dès le démarrage de la pompe, il s'établit une circulation du liquide refoulé par la pompe en provenance des passages axiaux 10 et 11. Cette circulation de liquide entraîne en quelques minutes l'air contenu dans la chambre de rotor 8 et dans la chambre de palier 23 pour le ramener, via le passage central foré 5, à l'aspiration de la pompe 1 d'où il est refoulé dans le circuit de pompage jusqu'à des purgeurs automatiques. On remarque, montée serrée sur l'arbre 3 avant les passages 7, une collerette 22a qui sert de butée axiale de l'arbre 3 sur le palier 22 afin d'éviter que l'extrémité 33 de cet arbre ne vienne porter sur le support 31.

Le système de palier selon l'invention, représenté à la figure 3, permet une intervention manuelle pour assurer le dégommage éventuel du rotor 13 du moteur. Les pièces remplissant les mêmes fonctions qu'à la figure 2 portent les mêmes repères de référence. On remarque tout d'abord que la chambre de palier 23 est isolée par une pièce 34 laissant passer seulement de faibles fuites au contact de l'extrémité de l'arbre tournant 3, par rapport au passage axial 32 qui débouche alors sur une chambre intermédiaire 23a reliée à des passages radiaux 35 débouchant sur le passage central foré 5 dont l'extrémité débouchant sur la chambre de palier 23 est obturée par un opercule serti 36 afin de fermer la face d'extrémité 33 de l'arbre 3. La chambre de palier 23 peut être ouverte vers l'extérieur en dévissant un bouchon fileté 37 vissé de façon étanche (à l'aide d'un joint annulaire 38) dans le support de palier 31.

Dans le mode de réalisation représenté sur la figure 3, s'il se produit un échauffement de palier 22, le liquide qui circule via le passage axial 32, la chambre intermédiaire 23a et le passage foré 5, limite l'amplitude de cet échauffement. Si le rotor du moteur électrique est bloqué, il suffit de déposer le bouchon 37 pour faire tourner le rotor à l'aide de la fente 30, la pièce 34 s'opposant à toute fuite importante de liquide pendant cette opération de dégommage du rotor 13.

Les moteurs électriques utilisés pour l'entraînement des pompes sont généralement des moteurs asynchrones qui présentent l'avantage d'un prix modéré, d'une grande résistance mécanique et d'éviter, dans la solution à tube d'entrefer, d'avoir à disposer d'un joint tournant étanche car, comme montré à la figure 1, le rotor du moteur électrique est directement immergé dans le liquide pompé et est entraîné uniquement par induction et effet magnétique, c'est-à-dire sans aucun contact avec le stator 14. Pour les faibles puissances, on utilise généralement des moteurs asynchrones monophasés à phase auxiliaire permanente à condensateur, ce qui assure le démarrage automatique et un bon rendement relatif du moteur ainsi qu'un excellent facteur de puissance en courant alternatif (cosinus phi). La solution à moteur asynchrone monophasé à spires de court-circuit de déphasage donne de meilleurs couples de démarrage en court-circuit mais ne présente pas d'aussi bonnes qualités de rendement et de facteur de puissance.

Pour les puissances plus élevées correspondant par exemple aux circulateurs de chauffage central d'immeubles, le moteur asynchrone triphasé est généralement utilisé et le système de palier selon l'invention nécessite, pour son exploitation correcte, d'être combiné à un détecteur de sens de rotation du moteur permettant d'assurer le branchement des phases garantissant la rotation du moteur dans le sens exigé par l'inclinaison des aubages du rotor centrifuge de la pompe.

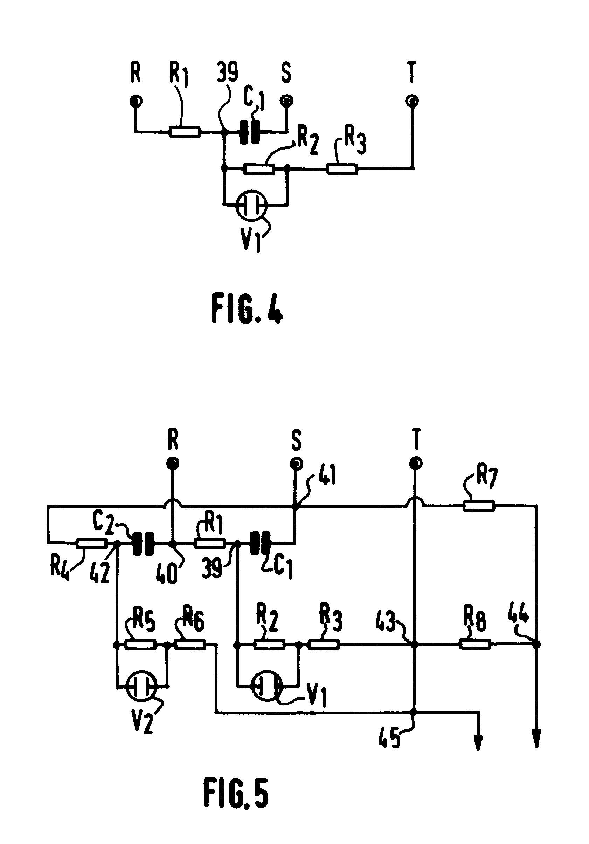

Un premier mode de réalisation du circuit électrique de détection du sens de rotation combiné au système de palier selon l'invention est représenté sur la figure 4. Entre deux premières phases R et S des phases du moteur, est branché un circuit déphaseur résistance-capacité constitué d'une résistance R₁ (de par exemple 330 kΩ, puissance 1/2 W en 380 V) et d'un condensateur (par exemple 10 nF, 400 V).

Au point milieu 39 entre la résistance R₁ et la capacité C₁, on vient brancher un circuit diviseur de tension à deux résistances supplémentaires R₂ (par exemple 240 kΩ, 1/2 W) et R₃ (par exemple 220 kΩ, 1/2 W) qui relie le point milieu 39 à la troisième phase T du bobinage stator du moteur 4. En disposant une lampe V₁ aux bornes de la résistance R₂ (par exemple un petit tube néon s'allumant à partir de 85 à 110 V), on dispose ainsi d'un indicateur de sens de rotation de très faible encombrement et que l'on peut inclure dans la boîte à bornes 26 en laissant dépasser vers l'extérieur la lampe V₁ qui, lorsqu'elle est allumée, indique à la fois que le moteur est branché sur le réseau triphasé selon un ordre des phases lui assurant le sens de rotation correct et que le moteur est mis sous tension.

L'allumage du tube néon V₁ indiquant la présence aux bornes de la résistance R₂ d'une tension minimale de l'ordre de 85 V est dû au fait que la tension au point milieu 39 est déphasée en avance d'environ 90° (aux fuites et pertes diélectriques près) par le condensateur C₁ et se trouve dans un cas de branchement des phases (et donc pour un sens de rotation du moteur) en phase avec la tension à la troisième phase T, le tube néon V₁ étant éteint et, dans l'autre cas de branchement des phases, en opposition de phase avec la tension de la troisième phase T, le tube néon V₁ étant alors allumé.

Dans le deuxième mode de réalisation (représenté à la figure 5) du circuit de détection du sens de rotation combiné au système de palier selon l'invention représenté sur la figure 3, on reprend pour les phases R, S, T, le montage du détecteur de sens de rotation représenté à la figure 4, permettant à un détecteur à tube néon V₁ de s'allumer uniquement lorsque le moteur 4 est sous tension et que le branchement des phases correspond à un sens de rotation déterminé du moteur.

Afin de disposer d'un deuxième indicateur de sens de rotation du moteur s'allumant lorsque le moteur 4 est branché pour tourner dans le sens inverse, on dispose entre les phases R et S un deuxième circuit déphaseur constitué sensiblement des mêmes éléments résistance-capacité R₄, C₂, que le premier circuit déphaseur mais avec une position inverse du condensateur C₂ qui est branché du côté de la borne 40 de la phase moteur R et en plus du côté de la borne 41 de la phase moteur S. Le point milieu 42 entre la résistance R₂ et la capacité C₂ est alors relié à la troisième phase moteur T via un second circuit diviseur R₅, R₆ analogue au premier circuit diviseur R₂, R₃. Un indicateur de tension, constitué par exemple à nouveau d'un tube néon V₂, est branché aux bornes de la résistance R₅ de telle manière que pour un sens de branchement des phases moteur triphasé, R, S, T sur le réseau, ce soit la lampe néon V₁ qui s'allume et que pour l'autre sens de branchement des phases moteur R, S, T sur le réseau, ce soit la lampe néon V₂ qui s'allume.

Grâce au circuit représenté à la figure 5, on dispose d'un indicateur de sens de rotation qui indique, pour les deux sens de rotation, à la fois le sens de rotation du branchement des phases et la présence de la tension d'alimentation sur le bobinage du moteur. Pour compléter le circuit de la figure 5 afin de l'adapter à la télésurveillance, on peut relier un point milieu de la tension entre les phases S et T (entre des résistances R₇ et R₈ de, par exemple, 180 kΩ) branchées aux bornes respectives 43 et 41 pour adresser, via une borne de prélèvement 44 branchée entre les résistances R₇ et R₈ et une borne de prélèvement 45 branchée sur la borne 43 de la phase T, un signal de présence de tension sur le moteur 4 à une installation de télésurveillance non représentée.

Grâce au système de palier qui vient d'être décrit et qui est représenté sur la figures 3, combiné aux détecteurs de sens de branchement (et donc en fait de rotation) du moteur électrique d'entraînement selon les figures 4 et 5, on peut disposer de groupes motopompes beaucoup plus résistants et fiables et surtout beaucoup plus faciles à installer sur un circuit de liquide, tel qu'un circuit d'eau de chauffage, de surpression ou de relevage d'eau.

## Revendications

1. Groupe motopompe, notamment pour un circuit d'eau de chauffage, comportant un arbre de rotor (3) porté par deux paliers (19, 22) et solidaire d'un rotor (13) de moteur électrique (4) noyé dans un circuit de liquide de rotor qui est délimité par un tube d'entrefer (12) du moteur électrique et est établi en dérivation entre la périphérie du rotor de pompe (2) et un retour via un passage axial (5) de l'arbre (3) du rotor du moteur, le système de palier arrière de l'arbre (3) du moteur (4), situé du côté opposé au rotor de pompe (2) comportant au moins un passage de palier (32, 23, 5a; 32, 23a, 35) branché en dérivation du circuit de liquide de rotor qui revient au circuit aval (1) de la pompe à travers l'arbre (3) du rotor (13) du moteur électrique, de manière à réaliser la purge automatique du circuit de liquide de rotor (2) et notamment de la zone dudit palier arrière, l'extrémité de l'arbre (3) de rotor du moteur électrique située près dudit palier arrière comportant au moins un passage radial (35) de retour au circuit de liquide de rotor débouchant sur le passage axial (5) de l'arbre (3) de rotor de moteur électrique, caractérisé en ce qu'un moyen (34) d'étanchéité tournante au moins partielle est interposé entre l'arbre (3) de rotor du moteur électrique et le support de palier arrière (31) pour isoler au moins partiellement ledit passage de dérivation (32, 23a) de la face d'extrémité (33) de l'arbre de rotor (3) qui débouche sur une chambre de palier (23) fermée par un bouchon amovible (37) permettant d'observer cette face d'extrémité (33) de l'arbre (3) pour déterminer si l'arbre tourne, et dans le cas où il ne tourne pas, alors que le moteur électrique est sous tension, procéder à son dégommage.

2. Groupe motopompe selon la revendication 1, caractérisé en ce que le système de palier arrière coopère avec un détecteur électrique (R₁, C₁, R₂, R₃, V₁) du sens de rotation du rotor du moteur électrique.

3. Groupe motopompe selon la revendication 2, caractérisé en ce que, dans le cas où le moteur électrique est un moteur asynchrone triphasé, le détecteur électrique du sens de rotation est constitué par un circuit déphaseur résistance (R₁)-capacité (C₁) branché entre les deux premières phases (R, S) du moteur électrique (4) alors qu'un diviseur de tension à deux résistances supplémentaires (R₂, R₃) est branché, d'une part, entre la résistance (R₁) et le condensateur (C₁) du circuit déphaseur et, d'autre part, à la dernière phase (T) du moteur électrique et en ce qu'un détecteur de tension minimale, tel qu'un tube néon (V₁), est branché aux bornes de celle (R₂) des deux résistances supplémentaires qui est branchée entre la résistance (R₁) et le condensateur (C₁) du circuit déphaseur, la présence d'une tension minimale sur le détecteur de tension (V₁) indiquant un premier sens de rotation du moteur électrique et l'absence de tension indiquant le deuxième sens de rotation du moteur électrique.

4. Groupe motopompe selon les revendications 2 et 3, caractérisé en ce que, dans le cas où le moteur électrique est un moteur asynchrone triphasé, le détecteur électrique comporte deux premiers circuits déphaseurs résistance-capacité (R₁, C₁; R₄, C₂) branchés entre deux premières phases (R, S) du moteur électrique (4), en parallèle et selon des positions résistance-capacité opposées, deux circuits diviseurs de tension (R₂, R₃; R₅, R₆) à deux résistances supplémentaires, et correspondant chacun à l'un des deux circuits déphaseurs étant chacun branchés d'une part entre la résistance (R₁, R₄) et le condensateur (C₁, C₂) du circuit déphaseur correspondant, et d'autre part la troisième phase (T) du moteur électrique et un détecteur de tension minimale tel qu'un tube néon (V₁, V₂) étant branché aux bornes de celle des deux résistances supplémentaires (R₂, R₃; R₅, R₆) qui est branchée entre la résistance (R₁, R₄) et le condensateur (C₁, C₂) du circuit déphaseur, de manière que la présence d'une tension minimale sur le premier détecteur de tension (V₁) indique un premier sens de rotation du moteur (4) et que la présence d'une tension minimale sur le deuxième détecteur de tension (V₂) indique le deuxième sens de rotation du moteur électrique (4).

5. Groupe motopompe selon les revendications 3 et 4, caractérisé en ce que le détecteur de tension (V₁, V₂) est monté sur un boîtier de surveillance (26) ou de télésurveillance du moteur, en indicateur unique pour servir simultanément de détecteur du sens de rotation correct du moteur et de détecteur de la présence de la tension d'alimentation du moteur électrique.

## Claims

1. Motor-driven pump assembly, notably for a heating water circuit, comprising a rotor shaft (3) carried by two bearings (19, 22) and rigidly fixed to a rotor (13) of an electric motor (4) completely carried inside a rotor fluid circuit which is delimited by an air gap tube (12) of the electric motor and is set up as a bypass between the periphery of the rotor of the pump (2) and a return path via an axial passage (5) in the rotor shaft (3) of the motor (3), the rear bearing system of the shaft (3) of motor (4), located facing the rotor of pump (2) including at least one bearing passage (32, 23, 5a; 32, 23a, 35) connected as a bypass to the rotor fluid circuit and returning to the downstream circuit (1) of the pump via the shaft (3) of the rotor (13) of the electric motor, in order to ensure automatic purging of the fluid circuit of rotor (2) and notably of the region of said rear bearing, the end of shaft (3) of the rotor of the electric motor located close to said rear bearing including at least one radial passage (35) for return to the rotor fluid circuit, discharging into the axial passage (5) of shaft (3) of the electric motor rotor, characterized in that at least a partial rotation sealing means (34) is inserted between the shaft (3) of the electric motor rotor and the rear bearing support (31) in order to at least partially isolate said bypass passage (32, 23a) from the end face (33) of the rotor shaft (3), said rotor shaft terminating in a bearing chamber (23) which is closed off by a removable plug (37) enabling said end face (33) of the shaft (3) to be viewed in order to determine if the shaft is rotating, and in the case where it is not rotating, the electric motor being powered up, to free the shaft of the motor which has seized up.

2. Electrically-driven pump unit according to claim 1, characterized in that the rear bearing system cooperates with an electrical detector (R₁, C₁, R₂, R₃, V₁) for the direction of rotation of the rotor of said electric motor.

3. Motor-driven pump unit according to claim 2, characterized in that, in the case where the electric motor is a three-phase asynchronous motor, the electrical detector for the direction of rotation consist of an R-C phase-shifting circuit (R₁)-(C₁) connected between the two first phases (R, S) of the electric motor (4), one end of a voltage divider comprising two additional resistors (R₂, R₃) being connected to said resistor (R₁) and the capacitor (C₁) of said phase-shifting circuit and the other end being connected to the last phase (T) of the electric motor, and in that a minimum voltage detector, such as a neon lamp (V₁), is connected across the terminals of that one (R₂) of said two additional resistors which is connected between the resistor (R₁) and the capacitor (C₁) of said phase-shifting circuit, the presence of a minimum voltage on the voltage detector (V₁) indicating a first direction of rotation of the electric motor, and the absence of voltage thereat indicating the second direction of rotation of the electric motor.

4. Motor-driven pump unit according to claims 2 and 3, characterized in that, in the case where the electric motor is a three-phase asynchronous motor, said electric detector comprises two first R-C phase-shifting circuits (R₁, C₁; R₄, C₂) connected between two first phases (R, S) of the electric motor (4), in parallel, and with the resistor and capacitor positions reversed, two voltage divider circuits (R₂, R₃; R₅, R₆) comprising two additional resistors, and each corresponding to one of two phase-shifting circuits being each connected, at one end, to the resistor (R₁, R₄) and the capacitor (C₁, C₂) of the corresponding phase-shifting circuit, and, at the other end thereof, to the third phase (T) of the electric motor, a minimum voltage detector, such as a neon lamp (V₁, V₂) being connected across the terminals of that one of said two additional resistors (R₂, R₃; R₅, R₆) which is connected between the resistor (R₁, R₄) and the capacitor (C₁, C₂) of the phase-shifting circuit, whereby the presence of a minimum voltage on the first voltage detector (V₁) indicates a first direction of rotation of the motor (4), and the presence of a minimum voltage on the second voltage detector (V₂) indicates the second direction of rotation of the electric motor (4).

5. Motor-driven pump unit according to claims 3 and 4, characterized in that the voltage detector (V₁, V₂) is mounted on a monitoring (26) or remote monitoring subassembly of the motor, as a single indicator to simultaneously act as a detector for the correct direction of rotation of said motor and for detecting the presence of the supply voltage on the electric motor.

## Patentansprüche

1. Motorpumpe, insbesondere für einen Heizwasserkreislauf, bestehend aus einer Läuferwellle (3), die auf zwei Lagern (19, 22) ruht und mit einem Läufer (13) eines Elektromotors (4) fest verbunden ist, der in einem Läuferflüssigkeitskreislauf versenkt ist, welcher von einem Luftspaltrohr (12) des Elektromotors begrenzt wird und in Ableitung zwischen der Umfangslinie des Pumpenläufers (2) und einem Rücklauf über einen axialen Durchlaß (5) der Welle (3) des Motorläufers ausgeführt ist, wobei das hintere Lagersystem der Welle (3) des Motors (4), das sich auf der vom Pumpenläufer (2) abgewandten Seite befindet, mindestens einen Lagerdurchlaß (32, 23, 5a; 32, 23a, 35) aufweist, der eine Ableitung von dem Läuferflüssigkeitskreislauf bildet, der durch die Welle (3) des Läufers (13) des Elektromotors zu dem pumpenauslaßseitigen Kreislauf (1) zurückkehrt, so daß die automatische Entleerung des Läuferflüssigkeitskreislaufs (2) und insbesondere des Bereichs des genannten hinteren Lagers durchgeführt wird, wobei das Ende der Läuferwelle (3) des Elektromotors, das sich nahe bei dem genannten hinteren Lager befindet, mindestens einen radialen Rückkehrdurchlaß (35) zu den Läuferflüssigkeitskreislauf aufweist, der in den axialen Durchlaß (5) der Läuferwelle (3) des Elektromotors mündet, dadurch gekennzeichnet, daß ein drehendes wenigstens teilweise dichtendes Abdichtungsmittel (34) zwischen der Läuferwelle (3) des Elektromotors und dem hinteren Lagerbock (31) angeordnet ist, um wenigstens teilweise den genannten Ableitungsdurchlaß (32, 23a) von der Endseite (33) der Läuferwelle (3) zu isolieren, die in eine Lagerkammer (23) mündet, die von einem abnehmbaren Deckel (37) verschlossen wird, der es ermöglicht, diese Endseite (33) der Welle (3) zu beobachten, um festzustellen, ob die Welle dreht, und, falls sie bei eingeschaltetem Elektromotor nicht dreht, sie loszubrechen,

2. Motorpumpe nach Anspruch 1,
dadurch gekennzeichnet, daß das hintere Lagersystem mit einem elektrischen Sensor (R₁, C₁, R₂, R₃, V₁) für die Drehrichtung des Elektromotorläufers zusammenarbeitet.

3. Motorpumpe nach Anspruch 2,
dadurch gekennzeichnet, daß, falls der Elektromotor ein Drehstrom-Asynchronmotor ist, der elektrische Drehrichtungssensor von einem Widerstand (R₁) - Kapazität (C₁) - Phasenschieberkreis gebildet wird, der zwischen die beiden ersten Phasen (R, S) des Elektromotors (4) geschaltet ist, während ein Spannungsteiler mit zwei zusätzlichen Widerständen (R₂, R₃) einerseits zwischen den Widerstand (R₁) und den Kondensator (C₁) des Phasenschieberkreises und andererseits an die letzte Phase (T) des Elektromotors geschlossen wird, und daß ein Minimalspannungssensor wie etwa eine Neonröhre (V₁) an die Klemmen von demjenigen (R₂) der beiden zusätzlichen Widerstände geschlossen wird, der zwischen dem Widerstand (R₁) und dem Kondensator (C₁) des Phasenschieberkreises angeschlossen ist, wobei das Vorhandensein einer Minimalspannung am Spannungssensor (V₁) eine ersta Drehrichtung des Elektromotors angibt, und das Nichtvorhandensein von Spannung die zweite Drehrichcung des Elektromotors angibt.

4. Motorpumpe nach den Ansprüchen 2 und 3,
dadurch gekennzeichnet, daß, falls der Elektromotor ein Drehstrom-Asynchronmotor ist, der elektrische Drehrichtungssensor zwei erste Widerstand-Kapazität-Phasenschieberkreise (R₁, C₁; R₄, C₂) aufweist, die zwischen zwei erste Phasen (R, S) des Elektromotors (4) geschaltet sind, während parallel und gemäß entgegengesetzten Widerstands-Kapazitäts-Positionen zwei Widerstandsteiler (R₂, R₃; R₅, R₆) mit zwei zusätzlichen widerständen, die jeweils einem der beiden Phasenschieberkreise entsprechen, jeweils einerseits zwischen den Widerstand (R₁, R₄) und den Kondensator (C₁, C₂) des entsprechenden Phasenschieberkreises und andererseits an die dritte Phase (T) des Elektromotors geschlossen sind, und wobei ein Minimalspannungssensor wie etwa eine Neonröhre (V₁, V₂) an die Klemmen von demjenigen der beiden zusätzlichen Widerstände (R₂, R₃; R₅, R₆) geschlossen wird, der zwischen den Widerstand (R₁, R₄) und den Kondensator (C₁, c₂) des Phasenschieberkreises geschlossen ist, so daß das Vorhandensein einer Minimalspannung am ersten Spannungssensor (V₁) eine erste Drehrichtung des Motors (4) angibt, und das Vorhandensein einer Spannung am zweiten Spannungssensor (V₂) die zweite Drehrichtung des Elektromotors (4) angibt.

5. Motorpumpe nach den Ansprüchen 3 und 4,
dadurch gekennzeichnet, daß der Spannungssensor (V₁, V₂) an einem Überwachungskasten (26) oder Fernüberwachungskasten für den Motor mit einer einzigen Anzeige angebracht ist, um gleichzeitig als Sensor für die richtige Drehrichtung des Motors und als Sensor für das Vorhandensein der Betriebsspannung des Elektromotors zu fungieren.
